# EUROPEAN PATENT APPLICATION

(11) **EP 1 628 338 A1**
(43) Date of publication of application: **22.02.2006**
(21) Application number: 04019693.3
(22) Date of filing: 19.08.2004
(51) Int. Cl.: H01L 21/56, H01L 23/495, H01L 23/498

(54) **The manufacturing method of a modularized leadframe**

(71) Applicant: OPTIMUM CARE INTERNATIONAL TECH. INC., Neihu District, Taipei City 114 (TW)
(72) Inventor: Lien, Jeffrey, Shihlin District Taipei City 111 Taiwan (CN)
(74) Representative: Beck, Michael Rudolf

(57) **Abstract**

A manufacturing method of a modularized leadframe, using a first mold set to paste and hold the upper surface of rows of multiple block leads, using a second mold set to paste and hold at least one selected surface of the lower surface of leads, let second mold set form a protruding part among each row of leads, let the surface of the protruding part be in close contact with the inner surface of the first mold set, then the hollow space between mold sets is injected with packaging materials such that a leadframe structure is formed with leads fixed and wire-bonding surface and soldering surface exposed,a hollow space is formed in the leadframe for later wire-bonding operation after chip is attached in the space.

## Description

### BACKGROUND OF THE INVENTION

### 1.Field of the Invention:

This invention is related to a manufacturing method and design of modularized leadframe, it is more specifically related to pre-package leads, it is further related to manufacturing method and design of selectively supplying leadframe package semi-product or product with chip attached.

### 2.Description of the Related Art:

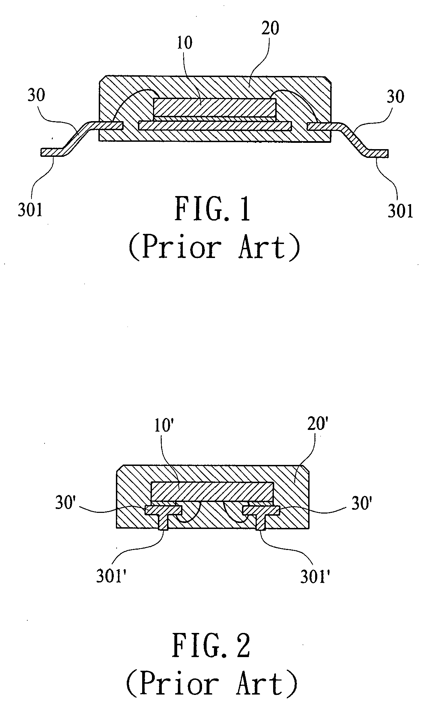

As shown in figure 1, in conventional package structure, semiconductor chip 10 is enclosed in thermo-setting or ceramic material package body 20 to form a hermetic seal. The leads 30 (leadframe) on both sides of semiconductor chip 10 extend out the package body 20 such that the bottom surface 301 of leads 30 can be used as a soldering part to the printed circuit board, but this package structure suffers a drawback of too bulky; therefore, another package technology emerges where leads are only exposed at the bottom surface of the package body as soldering surface, this is as shown in figure 2, here semiconductor chip 10' is seated or attached on leads 30', then encapsulated body 20' is used to enclose the structure to form a hermetic package, the bottom surface 301' of leads 30' are exposed and in the same plane as the bottom surface of encapsulated body 20', this surface can be used as a soldering part to the printed circuit board, a further improvement on package size reduction can thus be obtained.

But the above-mentioned semiconductor whole package structure suffers a drawback that it can not be chosen arbitrarily on the wire-bonding methods or we can not perform wire-bonding operation according to actual needs or change leads number after it is packaged, therefore this kind of product is less flexible; furthermore, the bottom surface 301' of leads 30' are exposed and in the same plane as the bottom surface of encapsulated body 20', this easily leads to the penetration of encapsulated material 20' to the bottom surface 301' before it is solidified which in turn form defective and need-to-be-reworked burrs ,production cost and quality control cost is thus increased; moreover, normal chip has certain degree of packaging before it comes to assembly house, in addition, the assembly of semiconductor electronic components to printed circuit board is pretty complete in sealing status, the above-mentioned packaging operation which uses costly packaging material seems redundant and results in the difficulty of packaging production cost reduction.

### SUMMARY OF THE INVENTION

The main purpose of this invention is to provide a manufacturing method for modularized leadframe, using a first mold set to paste and hold the upper surface of rows of multiple block leads such that an uncovered and clean and shine surface is formed after packaging, using a second mold set to paste and hold at least one selective surface of the lower surface of leads such that an uncovered and clean and shine surface is formed after packaging, let second mold set form a protruding part among each row of leads, let the surface of the protruding part be in close contact with the inner surface of the first mold set, then the hollow space between mold sets is injected with packaging materials such that a leadframe structure is formed with leads fixed and wire-bonding surface and soldering surface exposed, a hollow space is formed in the leadframe for later wire-bonding and simple sealing operation after chip is attached in the space.

Another purpose of this invention is to provide a manufacturing method and design of modularized leadframe wherein the block leads of the leadframe comprising upper and lower surface and a middle upward dented wire-bonding surface, the lower surface and wire-bonding surface is pasted and held by second mold set such that when packaged it can form exposed wire-bonding surface and soldering surface for attaching to components such as printed circuit board.

### BRIEF DESCRIPTIONS OF THE DRAWINGS

Figure 1 shows the semiconductor package structure of prior art.
Figure 2 shows another semiconductor package structure of prior art.
Figure 3 shows leads and mold are put together in the manufacturing process for the current invention.
Figure 4 shows encapsulated material is injected to the mold in the manufacturing process for the current invention.
Figure 5 shows the top view of the formed leadframe for the current invention.
Figure 6 shows the assembly of chip and leadframe in the manufacturing process.
Figure 7 shows the package manufacturing process for the hollow part in the leadframe.
Figure 8 shows another embodiment where leads and mold are put together for the current invention.
Figure 9 shows another embodiment of the current invention with manufacturing material being injected into the mold.
Figure 10 shows the top side view for another embodiment of the current invention.
Figure 11 shows another embodiment of the Current invention where chip is assembled onto the leadframe.
Figure 12 shows another embodiment of the current invention where the hollow part in the leadframe is packaged.

### DETAILED DESCRIPTION OF THE PREFERRED EMBODIMENT

The manufacturing methods, package structure of the current invention and its purposes are described in detail in the followings by referring to the attached embodiment figures:

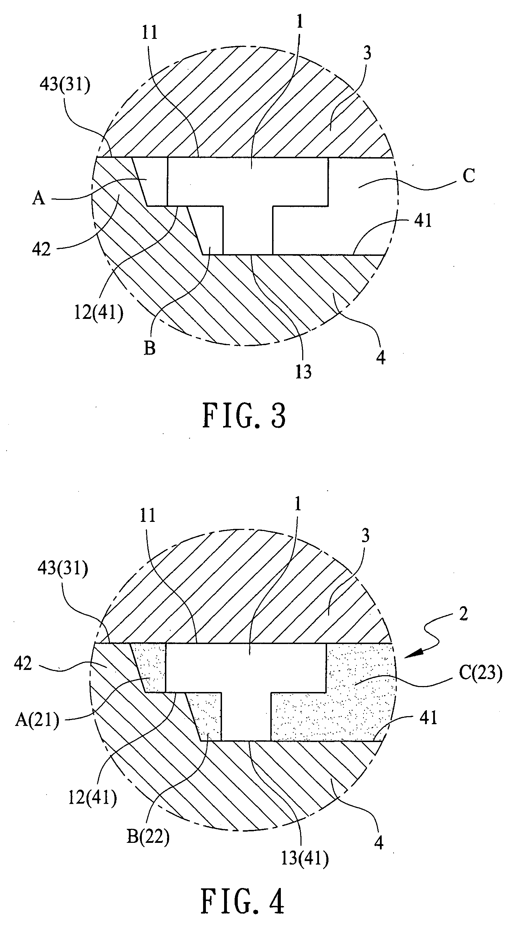

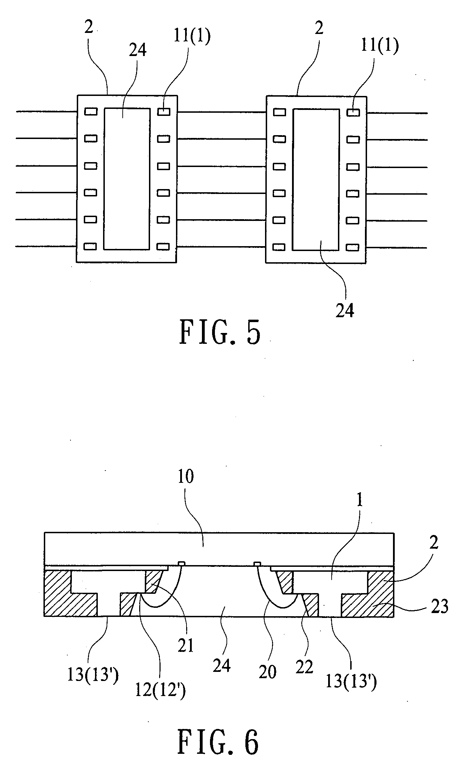

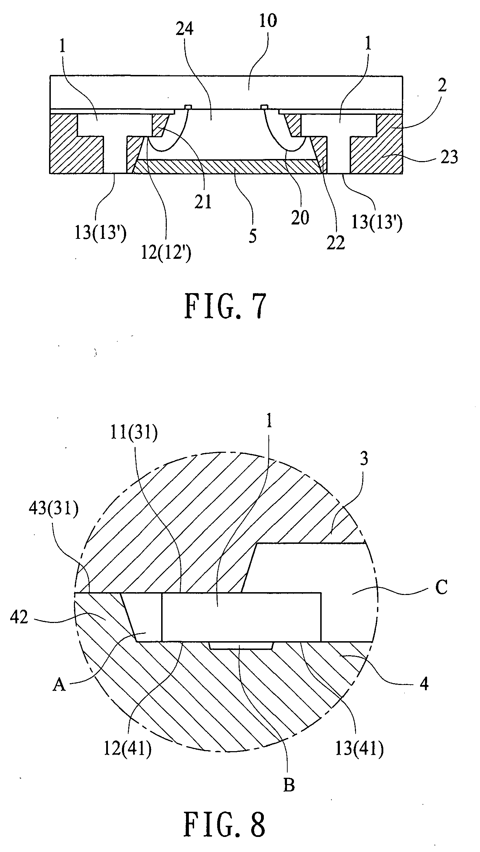

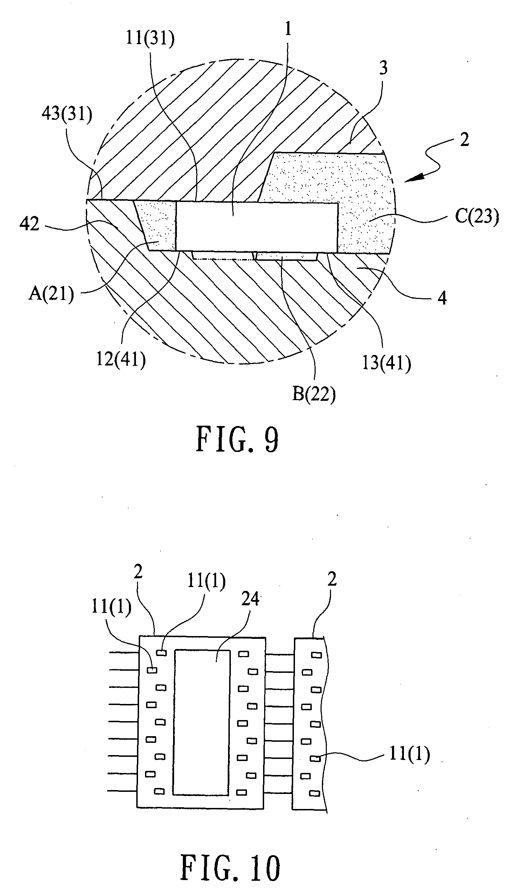

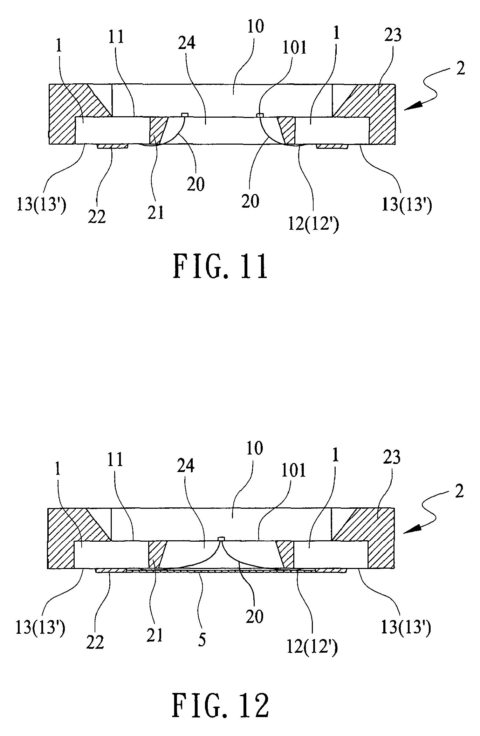

As shown in the appended figures, this invention is related to "the manufacturing method for modularized leadframe" design, it is a pre-packaged produced leadframe for the chip assembly and design of variable chip or leadframe, assembled product or semi-product can be supplied in selective way such that a more flexible manufacturing method can be obtained, it comprising:
(a) Select multiple metallic block leads 1 which has been diced or not diced, let leads 1 form at least two rows of symmetrical or asymmetrical arrangement ( please refer to figure 6 or figure 10 ) ;
(b) Use the inner surface 31 of the first mold set 3 to paste and hold the upper surface 11 of rows of multiple metallic block leads 1 such that after packaging the upper surface 11 will be shine surfaces without being covered by any unwanted matter, then use the inner surface 41 of the second mold set 4 to paste and hold at least one selected surface 12, 13 (it can also be one selected surface) at the lower part of leads 11 ,non-covered and shine surface can be formed after packaging ,also let the second mold set 4 form a protruding part 42 between each row of leads 1 such that surface 43 of the protruding part 42 face close to the inner surface 31 of the first mold set 3 (as shown in figure 3 and figure 8) ; thus hollow material filling spaces A,B,C are respectively formed between the inner side, outer side and bottom side of all the leads 1 which are seated in between the two mold sets 3 and 4;
(C) Inject packaging materials into materials filling space A,B,C lying between two mold sets 3 and 4 ( as shown in figure 4 and figure 9 ) such that all leads 1 are packaged together and its structure fixed by encapsulated body 2 ,inner fixing part 21 is formed in the material filling space A, lower fixing part 22 is formed in the material filling space B and side fixing part 23 is formed in the material filling space C, furthermore a hollow part 24 is formed in between at least two rows of leads 1,and let the upper surface 11 of lead 1 and at least one selected surface 12, 13 form an exposed structure such that its lower part can form a wire-bonding surface 12' and soldering surface 13', thus a leadframe which can accommodate chip 10 is formed (as shown in figure 5 and 10) ,a product that can provide space for chip 10 is thus completed;
(d) At least one chip 10 is attached to the upper surface of the above-mentioned completed fixed and packaged leadframe, perform wire-bonding operation with at least one metallic wire 20 between the connecting point 101 of the chip 10 and the wire-bonding surface 12' of lead 1 (that is, the originally selected surface), the wire bonding space is located at the hollow part 24 of encapsulated body 2 ( as shown in figure 6 and figure 11), thus a product that is ready to go with flexible choices is formed, this product can be arbitrarily soldered directly onto printed circuit board or other electrical device or other additional manufacturing processes can be performed on it;
(e) Please refer to figure 7 and 12, the bottom surface hollow part 24 of encapsulated body 2 can be selectively packaged for the second time after the completion of wire-bonding operation or other sealing material 5 can be used to form hermetic structure; because chip 10 and lead 1 has possessed package structure, functions such as moisture and dust prevention are existed in it, therefore cheaper plastic material can be selected and used in performing second packaging operation such that production cost can be greatly reduced;

Leadframe products manufactured by the method and design disclosed in this invention can thus be supplied to related customers, customers can then use them to perform wire-bonding or solder it directly onto printed circuit board, this product thus has more flexibility to suit to different application need; moreover, because in this invention the inner surfaces 31, 41 of first and second mold set 3, 4 are pasted to the upper surface 11 and lower selected surfaces 12, 13 of leads 1, therefore when leads 1 are packaged, the thermo-setting plastic or ceramic material will not penetrate into the upper surface 11 and the lower selected surface 12, 13, defects such as burrs will thus not appear on the exposed surface of leadframe product or semi-product and the burrs removing processes can then be saved and production and quality control cost can correspondingly be reduced; furthermore , because in this invention an upward hollow part 24 is formed on the bottom surface of encapsulated surface 2 when leads 1 is packaged completely, the bottom surface of chip 10 and the wire-bonding surface 12' of leads 1 are thus exposed, metallic wire 20 can then be selectively used to connect the bottom surface of chip 10 and the wire-bonding surface 12' of leads 1, then it is soldered to the printed circuit board directly, it thus greatly reduces packaging material cost, ordinary plastic sealing material or sealer 5 can be placed above the hollow part when the hollow part 24 need to be sealed, further saving in material cost can thus be achieved.

What needs to be pointed out in this invention is the lower fixing part 22 formed by the above-mentioned encapsulated body 2 is located at the lower part of leads 1, but the type it is formed at the lower part of leads 1 is not limited to align-to-each-other arrangement, it can be in cross and asymmetrical arrangement when the material filling space B is formed by second mold set 4 (please refer to figure 8 and 9) , the reason of doing such arrangement is to separate the exposed wire-bonding surface 12' and soldering surface 13' in order to reduce electromagnetic interference ( EMI ) effect; in the same way, the leads 1 mentioned above can also be in cross and asymmetrical arrangement such that wire-bonding surface 12' and soldering surface 13' are well separated ( please refer to figure 10) , the same effect can be achieved, for those skilled in the art, any simple modification or variation may be made therein without departing from the spirit of the invention or from the scope of the appended claims.

Summarize the above descriptions, current invention of "The manufacturing method of a modularized leadframe" does possess the required properties of utility and invention, its embodiments are also inventive, we therefore submit a new type patent application.

## Claims

1. A manufacturing method of a modularized leadframe comprising:
(a) selecting multiple metallic block leads forming at least an arrangement of two rows;
(b) pasting and holding the upper surface of row of multiple leads with the inner surface of a first mold set, pasting and holding at least a selected surface on the lower part of leads with an inner surface of second mold set, forming a protruding part among the leads of each row of lead by second mold set, pasting the surface of the protruding part closely with the inner surface of the first mold set, forming a hollow material filling space between the two mold sets;
(c) injecting packaging materials into the material filling space formed between two mold sets, forming an encapsulated body to fix and package all leads, the encapsulated body then forms a hollow part in between at least two rows of leads, let at least the upper surface of all leads and at least one selected surface expose to the outside, forming wire-bonding surface and soldering surface at the lower part, a leadframe is thus formed which can be used for assembly purpose for semiconductor chip.

2. The manufacturing method of a modularized leadframe of claim 1 wherein the completed packaged and fixed leads leadframe is attached later onto its upper part by at least one chip, then at least one metallic conducting wire is formed between the connecting points of the chip and the wire-bonding surface of leads where all these surfaces are located inside the hollow part of the encapsulated body.

3. The manufacturing method of a modularized leadframe of claim 2 wherein the hollow part in the encapsulated body can be alternatively performed a second time packaging or other sealer to form a hermetic structure after the completion of wire-bonding operation between chip and leads.

4. The manufacturing method of a modularized leadframe of claim 1 wherein all leads are in symmetrical or stagger asymmetrical arrangement before packaging operation.

5. The manufacturing method of a modularized leadframe of claim 1 wherein the lower part of leads pasted and held by the inner surface of second mold set has at least one selected surface which can be packaged in symmetrical or stagger asymmetrical arrangement.

6. The manufacturing method of a modularized leadframe of claim 1 wherein the material filling space is located at the inner, outer and bottom side of leads, the existence of material filling space makes the encapsulated body form inner fixing part, lower fixing part and side fixing part to the leads.
